# FASCICULE DE BREVET EUROPEEN

(11) **EP 0 446 121 B1**
(45) Date de publication et mention de la délivrance du brevet: **22.06.1994**
(21) Numéro de dépôt: 91400591.3
(22) Date de dépôt: 05.03.1991
(51) Int. Cl.: H01L 21/00

(54) **Porte soufflante pour conteneur de confinement ultrapropre**
Blastür für Behälter mit äusserst sauberer Einschliessung
Blowing door for container of extremely clean confinement

(30) Priorité: 07.03.1990 FR 9002871
(43) Date de publication de la demande: 11.09.1991
(73) Titulaire: COMMISSARIAT A L'ENERGIE ATOMIQUE, 75015 Paris (FR)
(72) Inventeur: Cruz, Didier, F-38100 Grenoble (FR); Daval, Jacques, F-38240 Meylan (FR)
(74) Mandataire: Dubois-Chabert, Guy

(56) Documents cités:
- EP-A- 0 340 345
- US-A- 4 278 380

## Description

Le domaine de l'invention est celui du stockage et du transfert d'objets devant être maintenus périodiquement ou constamment dans une atmosphère de très haute propreté.

Plus précisément, dans certains domaines de l'industrie, tels que celui de la microélectronique, on éprouve le besoin de maintenir dans une atmosphère de très haute propreté un ou plusieurs objets, tels que des plaques de silicium destinées à la fabrication des circuits intégrés, comme cela est décrit dans le document EP-A-0 340 345. On éprouve également le besoin de transférer souvent ce type d'objet de l'intérieur d'un premier conteneur à l'intérieur d'un deuxième conteneur. Se posent alors des problèmes relatifs à l'ouverture simultanée ou successive des deux conteneurs concernés. En effet, l'ouverture d'une porte nécessite un mouvement et des frottements mécaniques engendrant l'émission de quelques particules indésirables polluant l'atmosphère à haut degré de propreté. Ce même problème apparaît lors de la fermeture du conteneur, lorsque la porte de celui-ci est remise en place amenant inévitablement des particules provenant des différents frottements engendrés par l'ouverture et la fermeture. Ces particules peuvent également provenir de l'extérieur du conteneur car, lorsque la porte est montée coulissante, au moins une de ses faces se trouve, dans la position ouverte, en contact avec une atmosphère de bien moindre propreté.

Le problème que se propose de résoudre l'invention est celui de permettre un échange d'objets entre deux conteneurs "ultrapropres", sans introduire de particules plus ou moins polluées ou polluantes dans les atmosphères régnant à l'intérieur des deux conteneurs.

L'invention se rapporte à une porte soufflante telle que définie dans la revendication 1. Elle se rapporte aussi à un conteneur tel que défini en revendication 8. Des réalisations particulières de l'invention sont en outre définies dans les sous-revendications.

L'objet principal de l'invention est donc une porte soufflante pour conteneur de confinement ultrapropre, destinée à fermer hermétiquement un premier conteneur pouvant s'accoupler à un deuxième conteneur, le panneau de porte pouvant être déplacé pour permettre le passage d'objets de l'un des deux conteneurs dans l'autre, lorsque ceux-ci sont accouplés. La première face du panneau de porte est susceptible de faire face à l'intérieur du premier conteneur. Des moyens de fixation de la porte au premier conteneur sont prévus.

Selon l'invention, des moyens de ventilation d'au moins une face du panneau de porte sont prévus pour maintenir une atmosphère ultrapropre dans le proche environnement, en regard de cette face ventilée. L'invention prévoit également des premiers moyens d'étanchéité sur la première face du panneau de porte faisant face à,l'intérieur du premier conteneur.

L'invention se propose également d'adapter ce concept de porte soufflante aux portes coulissantes.

Dans ce but, le panneau de porte est monté coulissant dans un encadrement de porte destiné à être placé sur l'ouverture du premier conteneur. Il porte des premiers moyens d'étanchéité placés contre la première face du panneau de porte et des deuxièmes moyens d'étanchéité placés sur cet encadrement et destinés à être appliqués contre des moyens de fixation avec le deuxième conteneur.

Un des avantages de la porte soufflante selon l'invention est que celle-ci peut être utilisée avec un deuxième conteneur qui est, soit à étanchéité statique, soit à étanchéité dynamique. En effet, les moyens de raccordement avec le deuxième conteneur peuvent être constitués, soit par l'ouverture de ce deuxième conteneur qui est alors à étanchéité dynamique, soit par une deuxième porte soufflante, identique à la porte soufflante selon l'invention, les deux faces respectives des deux panneaux de porte faisant face à l'extérieur étant placées en regard l'une de l'autre. Dans ce cas, le deuxième conteneur est à étanchéité statique.

La réalisation principale des moyens de ventilation prévoit que ceux-ci soient constitués par un premier conduit d'arrivée de fluide sous pression alimentant une première chambre de fluide placée à l'intérieur de la porte soufflante et débouchant sur la première face du panneau de cette porte par un premier filtre.

Un des buts de l'invention est également de proposer une porte soufflante unique et utilisable avec deux conteneurs à étanchéité dynamique. A cet effet, le panneau de porte comprend des moyens de ventilation de sa deuxième face, pour maintenir une atmosphère ultrapropre dans le proche environnement en regard de ladite deuxième face.

Là encore, deux réalisations sont possibles.

La première prévoit que les deuxièmes moyens de ventilation de cette deuxième face soient constitués par un deuxième conduit d'arrivée de fluide sous pression alimentant une deuxième chambre de fluide placée à l'intérieur de la porte et débouchant sur la deuxième face du panneau de cette porte par l'intermédiaire d'un deuxième filtre.

La deuxième réalisation prévoit que ces deuxièmes moyens de ventilation sont constitués par les premiers, complétés d'un deuxième filtre débouchant sur la deuxième face du panneau de porte.

Dans le but d'utiliser d'une manière rationnelle la porte soufflante selon l'invention sur des conteneurs à étanchéité dynamique ou statique, on prévoit, pour les moyens de ventilation, une vanne placée en amont de leur chambre de fluide. Ceci permet de maintenir sous pression ou non, le conteneur lorsqu'il est fermé par la porte.

Un autre objet de l'invention est un conteneur ultrapropre équipé d'une porte soufflante telle qu'elle vient d'être décrite, l'encadrement de la porte faisant partie intégrante du conteneur.

Les avantages et les caractéristiques techniques de l'invention apparaîtront mieux à la lecture de la description suivante, donnée à titre d'exemple non limitatif. Elle est illustrée de plusieurs figures qui sont :
- figure 1, un schéma descriptif d'une première réalisation de la porte soufflante selon l'invention, représentée avec deux conteneurs avec lesquels elle est utilisée ;
- figures 1A, 1B, 1C, 1D et 1E, des schémas montrant les différentes phases de l'utilisation de la porte représentée sur la figure 1 ;
- figure 2A, une deuxième réalisation de la porte soufflante selon l'invention, représentée fixée à un conteneur avec lequel elle est utilisée ;
- figures 2B, 2C et 2D, des schémas représentant les différentes étapes du fonctionnement de la porte représentée sur la figure 2A ;
- figure 3, une troisième réalisation de la porte soufflante selon l'invention, fixée à un conteneur avec lequel elle est utilisée ;
- figure 4, une quatrième réalisation de la porte soufflante selon l'invention, représentée fixée à un conteneur avec lequel elle est utilisée.
- figure 5, une cinquième réalisation de la porte soufflante selon l'invention, sans filtre.

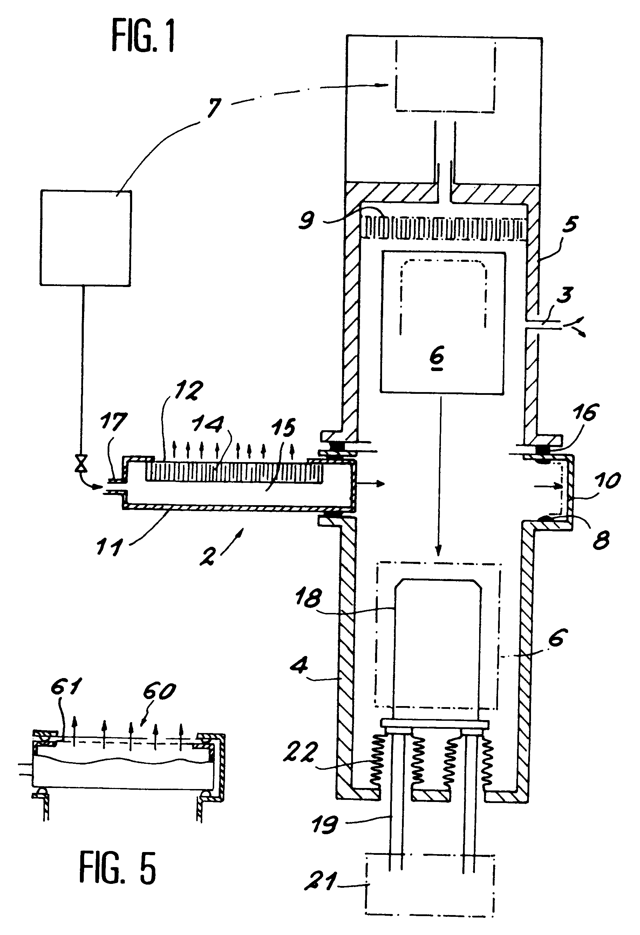

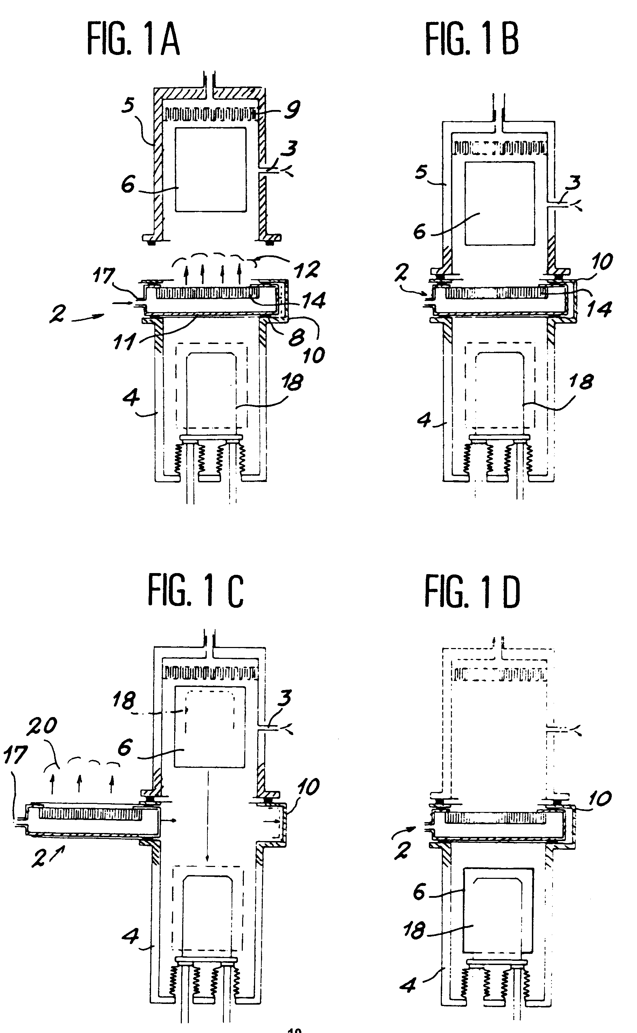

Pour présenter le concept de la porte soufflante selon l'invention, la figure 1A montre la première réalisation de cette porte et de son panneau 2, fixée à un conteneur 4, qui pour l'instant est vide. Ce schéma n'est qu'un exemple d'utilisation de cette première réalisation, le conteneur 4 pouvant très bien déjà contenir un ou plusieurs objets. Pour percevoir plus concrètement l'utilité de l'invention, on peut imaginer que le conteneur 4 est un conteneur de transfert vide, avant d'être rempli d'un ou plusieurs objets à stocker. En l'occurrence, il est destiné ici à recevoir un objet 6 stocké au préalable dans un deuxième conteneur 5 qui peut être un conteneur de stockage. Le conteneur de stockage 5 est représenté sans porte ; ceci signifie que c'est un conteneur à étanchéité dynamique. En effet, le domaine d'application de l'invention étant le traitement d'objets en atmosphère ultrapropre, ce conteneur de stockage 5 est relié à une source de fluide ultrapropre 7 qui est de préférence de l'air mais qui peut également être de l'argon, de l'azote, débouchant à l'intérieur de ce conteneur de stockage 5, de préférence par l'intermédiaire d'un filtre 9. L'objet 6 est ainsi placé temporairement dans ce conteneur de stockage 5 au milieu de filets d'air ultrapropres issus du filtre 9 sortant du conteneur de stockage 5 par l'ouverture de ce dernier.

Le panneau de porte soufflant 2 est fixé sur le conteneur de transfert 4 par une première face 11, ici la face intérieure, placée en regard de l'intérieur du conteneur de transfert 4. Des premiers moyens d'étanchéité sont prévus entre ce conteneur de transfert 4 et le panneau 2 et sont constitués de préférence d'un premier joint 8, tel qu'un joint torique. Plus précisément, le panneau 2 est fixé sur le conteneur de transfert 4 par l'intermédiaire d'un encadrement 10 supportant le panneau 2.

Cet encadrement de porte 10 a été représenté solidaire du conteneur de transfert 4, mais peut constituer une pièce séparée de celui-ci. Dans ce deuxième cas, il est fixé au conteneur de transfert 4 par des moyens classiques de fixation et d'étanchéité. Par exemple, cet encadrement 10 peut être monté pivotant par rapport au conteneur de transfert 4 au moyen d'un gond ou d'une charnière de porte à une première extrémité, la seconde extrémité venant contre le conteneur 4 pour y être fixée au moyen d'un loquet, d'une pince ou d'une vis. Une fois fixé sur le conteneur de transfert 4, l'encadrement 10 permet au panneau soufflant 2 de coulisser afin d'autoriser l'accès à l'intérieur du conteneur de transfert 4. Le premier joint d'étanchéité 8 constituant les premiers moyens d'étanchéité est placé plus précisément entre le panneau de porte 2 et l'encadrement de porte 10.

Une deuxième face 12 du panneau de porte 2, appelée externe, se trouve en regard du conteneur de stockage 5. Si une atmosphère normale, c'est-à-dire sans degré de propreté particulier, règne autour de ces deux conteneurs 4 et 5, on comprend que la face externe 12 du panneau soufflant 2 risque de polluer l'intérieur du conteneur de stockage 5 si ce dernier est placé contre cette face externe 12 par son ouverture. En effet, les particules diverses, telles que de simples poussières, reposent en grand nombre sur cette face externe 12 comme sur toutes les parois des objets se situant dans cette atmosphère sans degré de propreté particulier.

Pour remédier à cet inconvénient, l'invention prévoit d'équiper le panneau 2 de moyens de ventilation destinés à maintenir la face externe du panneau 2, ou plus précisément son proche environnement, sous une atmosphère ultrapropre. De cette manière, lorsque le conteneur de stockage 5 est approché de cette face externe 12, son intérieur n'est pas pollué par d'éventuelles particules se trouvant sur cette face externe 12. Ces moyens de ventilation sont, sur cette figure 1A, représentés par la source de fluide propre sous pression 7 à laquelle est raccordé un conduit 17 débouchant à l'intérieur de la porte soufflante 2 dans une chambre 15 s'étendant à l'intérieur du panneau 2 pour déboucher elle-même sur la face externe 12 par l'intermédiaire d'un filtre 14.

De manière à assurer également l'étanchéité entre le panneau soufflant 2 et le conteneur de stockage 5, des deuxièmes moyens d'étanchéité sont prévus entre l'encadrement 10 et le conteneur de stockage 5. Ils peuvent être réalisés de manière analogue aux premiers moyens d'étanchéité sous la forme d'un simple joint 16.

Les conteneurs 4 et 5 comme l'encadrement de porte 10 sont munis chacun de moyens de fixation respectifs de type classique.

Comme précisé auparavant, l'encadrement 10 peut néanmoins faire partie intégrante d'un des deux conteneurs 4, qui est alors équipé en permanence de la même porte.

Sur cette figure comme sur les autres, sont représentés des moyens de préhension et de transfert de l'objet 6 d'un conteneur à l'autre. Ces moyens ne font pas l'objet de la présente invention mais sont nécessaires pour effectuer le passage de l'objet d'un conteneur à l'autre. Ils peuvent être constitués pour un premier conteneur, d'une palette 18 sur laquelle repose(nt) le ou les objets stockés ou transportés 6. Cette palette 18 est mobile en translation grâce à deux tiges de manipulation 19 traversant les parois du conteneur au moyen de soufflets 22. Un dispositif de commande 21 placé à l'extérieur est prévu pour la manipulation de ces moyens de transfert. L'autre conteneur n'est pas obligé de posséder de tels moyens de transfert ; il peut simplement comporter des moyens de maintien du ou des objets.

Au début d'un cycle d'échange d'objets d'un conteneur à l'autre, lorsque les deux conteneurs 4 et 5 sont accouplés, si l'un deux est un conteneur à étanchéité dynamique, comme le conteneur de stockage 5 de la figure 1A, la pression à l'intérieur de celui-ci augmente pour se stabiliser à une valeur déterminée, grâce à un orifice de fuite 3 par lequel l'air sous pression s'échappe à l'extérieur du conteneur 5.

La figure 1B schématise cette phase du procédé d'utilisation de la porte selon l'invention. C'est-à-dire que l'objet 6 est toujours dans le conteneur de stockage 5 sous une atmosphère ultrapropre et sous pression. Les conteneurs 4 et 5 sont accouplés par l'intermédiaire de l'encadrement 10, mais le panneau 2 est toujours fermé.

En se reportant maintenant à la figure 1B, les deux conteneurs 4 et 5 restent accouplés au moyen de l'encadrement de porte 10 et des joints d'étanchéité 8 et 16.

En référence à la figure 1C, le panneau soufflant 2 est ensuite translaté par coulissement à l'intérieur de l'encadrement 10. Cette opération peut se faire automatiquement ou manuellement par exemple en tirant sur le conduit 17 de la source d'air sous pression. La chambre 15 du panneau soufflant 2 se trouve alimentée en air et la face externe 12 du panneau 2 se trouve donc ventilée, de sorte que son proche environnement se trouve sous une atmosphère ultrapropre. Cette zone propre a été représentée par le nuage repéré 20. A l'aide des moyens de transfert, le ou les objets 6 ont pu être changés de conteneur.

Comme le montre la figure 1D, le panneau soufflant 2 peut être a lors refermé, c'est-à-dire repoussé en sens contraire de manière à reprendre sa position initiale dans l'encadrement de porte 10. Dans cet exemple d'application, la face interne 11 du panneau soufflant 2 a été en contact avec l'atmosphère de l'extérieur. Cette face interne 11 se retrouve donc, une fois le panneau soufflant 2 refermé, au contact de l'intérieur du conteneur de transfert 4. Cette face interne 11 est donc susceptible de contaminer l'intérieur de ce conteneur de transfert 4. Il est donc supposé, dans cet exemple de réalisation, que les exigences à l'intérieur du conteneur de transfert 4 ne sont pas celles requises pour le stockage des objets sous une atmosphère ultrapropre. Ce léger inconvénient est supprimé dans les autres réalisations de la porte soufflante selon l'invention.

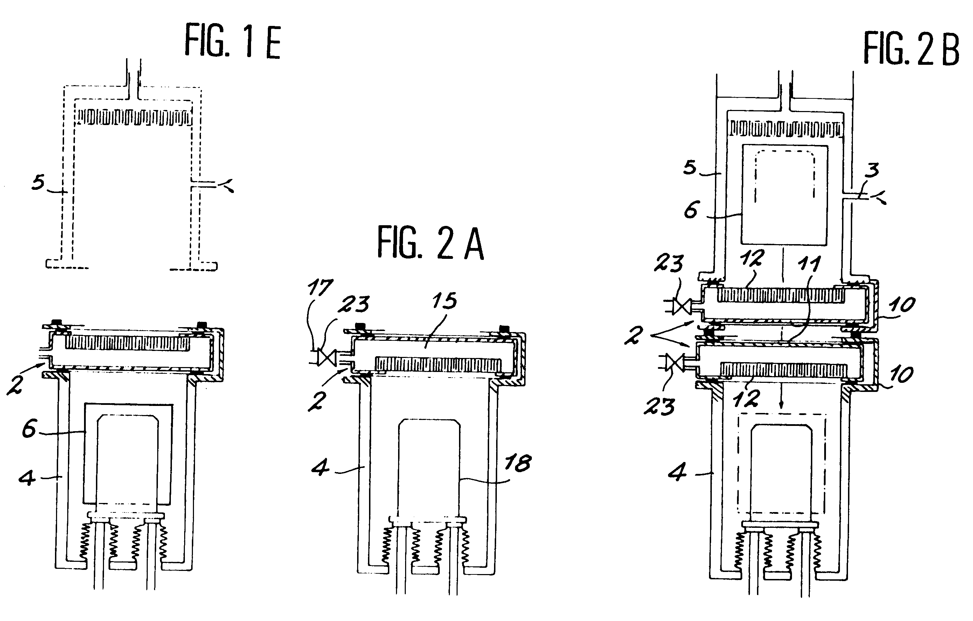

En référence à la figure 1E, le conteneur de stockage 5 peut finalement être désolidarisé de l'ensemble formé du panneau de porte 2, de son encadrement 10 et du conteneur de transfert 4.

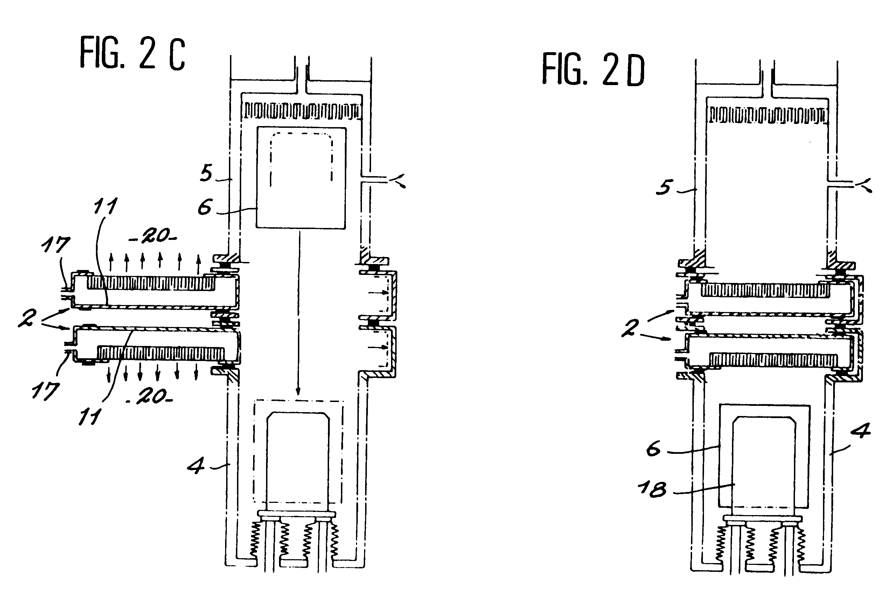

Dans la deuxième réalisation de la porte soufflante selon l'invention représentée par les figures 2A, 2B, 2C et 2D, le panneau est muni d'une vanne 23, placée sur la conduite 17 d'air sous pression, en amont de la chambre 15. Cette vanne 23 permet de commander sur place l'alimentation de cette chambre 15 du panneau soufflant 2, en fonction de l'utilisation qui est faite de ce panneau. En effet, pour éviter le léger inconvénient cité ci-dessus, on peut envisager un panneau soufflant avec la paroi interne ventilée. Cela revient à utiliser le panneau soufflant représenté précédemment et de le retourner pour que sa face, au préalable externe et repérée 12 sur les figures 1A à 1E, devienne la face interne sur cette série de figures 2A à 2D.

L'intérieur du conteneur de stockage 4 peut alors être soumis à une pression transmise par la porte soufflante.

En se reportant à la figure 2B, on peut constater qu'une telle porte peut être utilisée d'une manière différente de celle décrite précédemment.

En effet, on peut envisager chacun des deux conteneurs 4 et 5 à accoupler, munis chacun d'une porte soufflante, telle que décrite sur la figure 2A. Chacun des panneaux soufflants 2 est alors monté temporairement ou en permanence à un conteneur, de manière à ce que la face au préalable externe 12 se trouve vers l'intérieur du conteneur qu'il ferme. Chacun des deux panneaux soufflants 2 est complété d'un encadrement de porte 10. Dans ce cas, les moyens de fixation d'un conteneur à l'autre sont constitués en outre par des organes classiques de fixation entre les deux encadrements de portes 10. En mettant face à face les deux faces préalablement internes 11 des deux panneaux soufflants 2, il est ainsi possible d'accoupler les deux conteneurs 4 et 5. Ce mode d'utilisation de la porte soufflante selon l'invention avec sa face ventilée vers l'intérieur des conteneurs s'applique particulièrement au transfert d'objets entre deux conteneurs statiquement étanches, le but de l'invention étant de ne pas contaminer le volume interne de chacun des conteneurs.

Ce procédé d'utilisation s'emploie de préférence avec deux conteneurs sous pression. Une fois que ces derniers sont mis en contact par l'intermédiaire de leur porte soufflante respective, les vannes 23 sont ouvertes, mais sans apport de fluide sous pression de la part de la source de fluide sous pression. Il s'ensuit une chute de pression à l'intérieur des deux conteneurs 4 et 5 jusqu'à ce que celle-ci atteigne la valeur de la pression atmosphérique.

En référence à la figure 2C, les deux panneaux soufflants 2 solidarisés l'un à l'autre sont translatés vers l'extérieur pour permettre le passage de l'objet 6 stocké dans le conteneur de stockage 5 vers le conteneur de transfert 4. Les deux panneaux 2 se trouvant alors dans l'ambiance contaminée, les chambres respectives 15 des deux panneaux soufflants 2 sont mises sous pression par l'arrivée de fluide sous pression au moyen de la conduite 17. Le proche environnement des surfaces externes 12 des deux panneaux soufflants 2 est ainsi maintenu dans une atmosphère ultrapropre.

Comme le montre la figure 2D, une fois le passage de l'objet 6 du conteneur de stockage 5 dans le conteneur de transfert 4 effectué, les deux panneaux soufflants 2 sont translatés pour refermer le passage entre les deux conteneurs 4 et 5. Les surfaces externes 12 de ces deux panneaux soufflants 2 ayant été maintenues sous atmosphère ultrapropre pendant l'ouverture des deux panneaux 2, l'ambiance interne des deux conteneurs 4 et 5 n'est donc pas contaminée. La pression monte à l'intérieur des deux conteneurs 4 et 5. Lorsque celle-ci atteint la valeur de pression désirée, les vannes 23 sont fermées et les deux conteneurs 4 et 5 sont maintenus sous leur pression de fonctionnement, soit parce qu'ils sont étanches statiquement, c'est-à-dire hermétiquement clos, soit parce qu'ils sont sous étanchéité dynamique avec un orifice de fuite 3. Les deux conteneurs 4 et 5 peuvent ensuite être désolidarisés l'un de l'autre par la désolidarisation des deux encadrements de porte 10.

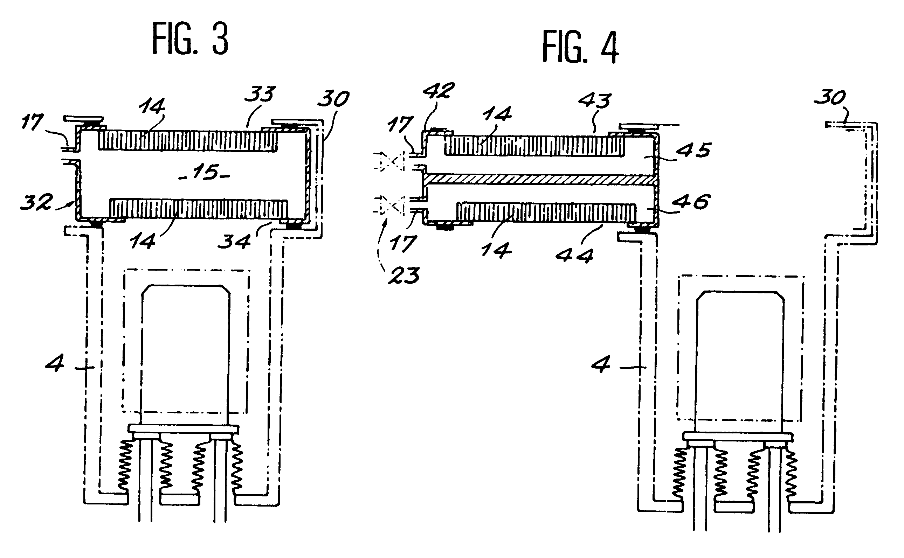

En référence à la figure 3, une troisième variante de la porte soufflante selon l'invention consiste à équiper un seul panneau soufflant 32 de deux faces 33 et 34 équipées chacune d'un filtre 14. La chambre interne 15 du panneau 32 étant toujours reliée à un conduit 17 provenant d'une source de fluide sous pression, les deux faces 33 et 34 du panneau 32 sont maintenues constamment sous une atmosphère de très haute propreté, grâce aux filets de fluide provenant de la chambre 15 et passant par les filtres 14. Dans ce cas, l'encadrement 30 de la porte est en contact à la fois avec les deux conteneurs 4 et 5, toujours au moyen de deux joints d'étanchéité 8 et 16. Cette solution permet de disposer d'un panneau 32 parfaitement propre quel que soit l'état de son environnement. Ce type de panneau soufflant 32 est utilisable pour des conteneurs devant travailler à une pression interne identique à celle de l'environnement externe. En outre, une seule porte suffit pour un couple de deux conteneurs.

Une quatrième réalisation de la porte soufflante selon l'invention est représentée par la figure 4. Le panneau soufflant 42 y est placé dans le même encadrement 30 utilisé avec la porte de la figure 3. Ce panneau soufflant 42 est un double panneau ; c'est-à-dire qu'il est constitué des deux panneaux utilisés simultanément dans les figures 2A, 2B, 2C et 2D. Un filtre 14 débouche sur chacune des deux faces 43 et 44. Par contre, chacune de ces faces et de leur filtre 14 est munie d'une chambre interne différente 45 et 46. Ces deux chambres 45 et 46 sont reliées chacune à une source d'air sous pression par l'intermédiaire d'un conduit 17 équipé d'une vanne 23.

Ce modèle est prévu pour être adapté sur des conteneurs devant travailler sous vide ou sous pression. Les types de portes soufflantes représentés par les figures 3 et 4 permettent d'effectuer en ambiance contaminée, des transferts d'objets entre un conteneur statiquement étanche, par exemple une boîte fermée, et un autre conteneur dynamiquement étanche, c'est-à-dire une boîte ouverte et ventilée et ceci sans contaminer les volumes internes respectifs des deux conteneurs.

Ces deux dernières réalisations permettent d'éviter l'inconvénient incombant à la première réalisation. Plus précisément, la face interne du panneau de porte ne peut pas être contaminée lorsqu'elle est ouverte, comme cela peut être le cas sur les figures 1C et 1D.

Dans les exemples de réalisation décrits ci-dessus, le fluide sous pression peut être plus ou moins propre, ce qui nécessite l'intégration d'un ou de deux filtres sur la porte. Mais, conformément à la figure 5, il est possible d'envisager que le fluide issu du conduit 17 ait déjà subi une filtration très poussée de manière à ce que sa propreté corresponde à celle des volumes internes des deux conteneurs. Dans ce cas, il est possible de remplacer les filtres précédemment utilisés par un ou deux diffuseurs 60 relativement plats sur une face 61. Par exemple, de la tôle finement perforée, des films poreux, des papiers, des céramiques ou des tamis peuvent être utilisés, leur rôle étant d'homogénéiser les flux de fluides de sortie.

Les différentes réalisations décrites dans cette description ne constituent que des exemples de réalisation du concept de la présente invention.

## Revendications

1. Porte soufflante pour conteneur de confinement à très haute propreté, destinée à fermer hermétiquement un premier conteneur (4) comportant une ouverture et pouvant être accouplée à un second conteneur (5) comportant une ouverture, comprenant:
- des moyens de fixation au premier conteneur (4);
- un panneau de porte (2, 32, 42) pouvant être déplacé, le passage à travers la porte d'objets plats (6) de l'un des deux conteneurs dans l'autre à travers leurs ouvertures lorsque ceux-ci sont accouplés par l'intermédiaire de la porte étant ainsi permis, ce panneau (2, 32, 42) comprenant une première face (11, 34, 44) et une deuxième face (12, 33, 43, 61), l'une des deux faces pouvant faire face à l'intérieur du premier conteneur (4), et des moyens de ventilation d'au moins ladite deuxième face (12, 33, 43, 61), une atmosphère de très haute propreté dans le proche environnement en regard de la ou des faces ventilées étant ainsi maintenue;
- des moyens d'étanchéité (8) de ladite face qui peut faire face à l'intérieur du premier conteneur (4).

2. Porte selon la revendication 1, caractérisée en ce que le panneau de porte (2, 32, 42) est un panneau coulissant et que la porte comprend un encadrement de porte (10, 30) placé sur l'ouverture du premier conteneur (4), ledit encadrement de porte (10, 30) portant lesdits moyens d'étanchéité (8) placés contre ladite face qui peut faire face à l'intérieur du premier conteneur (4) et portant aussi des deuxièmes moyens d'étanchéité (16) destinés à être placés contre des moyens de fixation au deuxième conteneur (5).

3. Porte selon la revendication 1 ou 2, caractérisée en ce que lesdits moyens de ventilation sont constitués d'une arrivée de fluide sous pression (17) alimentant une chambre de fluide (15, 45, 46) placée à l'intérieur du panneau de porte (2, 32, 42) et débouchant sur la ou les faces ventilées par l'intermédiaire d'un filtre (14).

4. Porte selon l'une quelconque des revendications 1 à 3, caractérisée en ce qu'elle comprend des moyens de ventilation de ladite première face (34, 44), une atmosphère de très haute propreté étant ainsi maintenue dans le proche environnement en regard de ladite première face (34, 44).

5. Porte selon la revendication 4 lorsque celle-ci dépend de la revendication 3, caractérisée en ce que les moyens de ventilation de ladite première face (44) sont constitués par une deuxième arrivée de fluide sous pression (17) alimentant une deuxième chambre de fluide (46) placée à l'intérieur du panneau de porte (42) et débouchant sur la première face (44) par un deuxième filtre (14).

6. Porte selon la revendication 4 lorsque celle-ci dépend de la revendication 3, caractérisée en ce que les moyens de ventilation de ladite première face (34) sont constitués des moyens de ventilation de ladite seconde face (33) constitués d'une arrivée de fluide sous pression (17) alimentant une chambre de fluide (15) placée à l'intérieur du panneau de porte (32) et débouchant sur ladite seconde face (33) par l'intermédiaire d'un premier filtre (14), complétés d'un deuxième filtre (14) débouchant sur la première face (34) du panneau de porte (32).

7. Porte selon l'une quelconque des revendications 4 à 6, caractérisée en ce que les moyens de ventilation comprennent chacun une vanne (23) placée en amont de leur chambre de fluide (15, 45, 46) sur la conduite d'air sous pression (17).

8. Conteneur (4) de confinement à très haute propreté comportant une porte soufflante selon la revendication 2, l'encadrement (10, 30) faisant partie intégrante du conteneur (4).

## Patentansprüche

1. Blastür für Behälter mit äußerst sauberer Einschließung, die dazu bestimmt ist, einen ersten Behälter (4) hermetisch abzuschließen, der eine Öffnung aufweist und an einen zweiten, eine Öffnung umfassenden Behälter (5) angekoppelt werden kann, umfassend:
- Befestigungseinrichtungen an dem ersten Behälter (4);
- eine Türwand (2, 32, 42), die bewegt werden kann, wobei somit der Durchtritt von flachen Gegenständen (6) durch die Tür von einem der zwei Behälter in den anderen durch ihre Öffnungen hindurch, wenn sie mittels der Tür aneinander gekoppelt sind, gestattet wird, diese Wand (2, 32, 42) eine erste Seite (11, 34, 44) und eine zweite Seite (12, 33, 43, 61) umfaßt, wobei eine der zwei Seiten zu dem Inneren des ersten Behälters (4) weisen kann, und Belüftungseinrichtungen auf wenigstens der genannten zweiten Seite (12, 33, 43, 61), wobei eine Atmosphäre sehr großer Sauberkeit in dem nahen Umfeld in bezug auf die eine oder auf die belüftete(n) Seite(n) somit aufrechterhalten wird;
- Abdichtungseinrichtungen (8) auf der genannten Seite, die zu dem Inneren des ersten Behälters (4) weisen kann.

2. Tür gemäß Anspruch 1, dadurch gekennzeichnet, daß die Türwand (2, 32, 42) eine verschiebbare Wand ist und daß die Tür eine Türumrahmung (10, 30) aufweist, die an der Öffnung des ersten Behälters (4) angeordnet ist, wobei die genannte Türumrahmung (10, 30) die genannten Abdichtungseinrichtungen (8) trägt, die an der genannten Seite angeordnet sind, die zu dem Inneren des ersten Behälters (4) weisen kann, und auch zweite Abdichtungseinrichtungen (16) trägt, die dazu bestimmt sind, gegen Befestigungseinrichtungen an dem zweiten Behälter (5) angeordnet zu werden.

3. Tür gemäß Anspruch 1 oder 2, dadurch gekennzeichnet, daß die genannten Belüftungseinrichtungen von einem Einlaß für ein Druckfluid (17) gebildet sind, das eine Fluidkammer (15, 45, 46) versorgt, die im Inneren der Türwand (2, 32, 42) angeordnet ist und auf der einen oder auf den belüfteten Seite(n) über ein Filter (14) mündet.

4. Tür gemäß irgendeinem der Ansprüche 1 bis 3, dadurch gekennzeichnet, daß sie Belüftungseinrichtungen der genannten ersten Seite (34, 44) umfaßt, wobei eine Atmosphäre sehr hoher Reinheit somit in dem nahen Umfeld in bezug auf die genannte erste Seite (34, 44) aufrechterhalten wird.

5. Tür gemäß Anspruch 4, dadurch gekennzeichnet, daß die Belüftungseinrichtungen der genannten ersten Seite (44) von einem zweiten Einlaß für ein Druckfluid (17) gebildet sind, das eine zweite Fluidkammer (46) versorgt, die im Inneren der Türwand (42) angeordnet ist und auf der ersten Seite (44) über ein zweites Filter (14) mündet.

6. Tür gemäß Anspruch 4, dadurch gekennzeichnet, daß die Belüftungseinrichtungen der genannten ersten Seite (34) von den Belüftungseinrichtungen der genannten zweiten Seite (33) gebildet sind, die von einem Einlaß für Druckfluid (17) gebildet sind, das eine Fluidkammer (15) versorgt, die im Inneren der Türwand (32) angeordnet ist und auf der genannten zweiten Seite (33) über ein erstes Filter (14) mündet, wobei sie durch ein zweites Filter (14) vervollständigt sind, das an der ersten Seite (34) der Türwand (32) mündet.

7. Tür gemäß irgendeinem der Ansprüche 4 bis 6, dadurch gekennzeichnet, daß jede der Belüftungseinrichtungen ein Ventil (23) umfaßt, das stromaufwärts ihrer Fluidkammer (15, 45, 46) in der Luftdruckleitung (17) angeordnet ist.

8. Behälter (4) mit äußerst sauberer Einschließung, der eine Blastür gemäß Anspruch 2 aufweist, wobei die Umrahmung (10, 30) einen integrierten Teil des Behälters (4) bildet.

## Claims

1. Blowing door for an ultra-clean confinement container for hermetically sealing a first container (4) having an opening and which can be coupled to a second container (5) having an opening comprising:
means for fixing to the first container (4),
a door panel (2, 32, 42) which can be displaced, the passage through the door of flat objects (6) from one of the two containers into the other through their openings when the latter are coupled by means of the door thus being permitted, said panel (2, 32, 42) having a first face (11, 34, 44) and a second face (12, 33, 43, 61), one of the two faces being able to face the interior of the first container (4), and means for ventilating at least said second face (12, 33, 43, 61), to maintain an ultra-clean atmosphere in the close environment facing the ventilated face or faces maintained in this way,
means (8) for sealing said face able to face the interior of the first container (4).

2. Door according to claim 1, characterized in that the door panel (2, 32, 42) is a sliding panel and that the door has a door frame (10, 30) placed on the opening of the first container (4), said door frame (10, 30) carrying said sealing means (8) placed against said face which can face the interior of the first container (4) and also carry second sealing means (16) to be placed against means for fixing to the second container (5).

3. Door according to claim 1 or 2, characterized in that said ventilating means are constituted by a pressurized fluid inlet (17) supplying a fluid chamber (15, 45, 46) placed within the door panel (2, 32, 42) and issuing onto the ventilated face or faces by means of a filter (14).

4. Door according to any one of the claims 1 to 3, characterized in that it comprises means for ventilating said first face (34, 44), so that an ultra-clean atmosphere is maintained in the close environment facing said first face (34, 44).

5. Door according to claim 4, when the latter is dependent on claim 3, characterized in that the ventilating means of said first face (44) are constituted by a second pressurized fluid inlet (17) supplying a second fluid chamber (46) placed within the door panel (42) and issuing onto the first face by a second filter (14).

6. Door according to claim 4 when it is dependent on claim 3, characterized in that the ventilating means of said first face (34) are constituted by the ventilating means for said second face (33) constituted by a pressurized fluid inlet (17) supplying a fluid chamber (15) located within the door panel (32) and issuing onto said second face (33) by means of a first filter (14), completed by a second filter (14) issuing onto the first face (34) of the door panel (32).

7. Door according to any one of the claims 4 to 6, characterized in that each of the ventilating means comprises a valve (23) positioned upstream of their fluid chamber (15, 45, 46) on the pressurized air pipe (17).

8. Ultra-clean confinement container (4) having a blowing door according to claim 2, the frame (10, 30) forming an integral part of the container (4).
